# FASCICULE DE BREVET EUROPEEN

(11) **EP 0 996 150 B1**
(45) Date de publication et mention de la délivrance du brevet: **01.07.2009**
(21) Numéro de dépôt: 99402555.9
(22) Date de dépôt: 18.10.1999
(51) Int. Cl.: H01L 21/822, H01L 21/762, H01L 21/84

(54) **Procédé de réalisation de composants passifs et actifs sur un même substrat isolant**
Herstellungsverfahren für passive und aktive Bauelemente auf demselben isolierten Substrat
Method of manufacturing passive and active devices on the same insulated substrate

(30) Priorité: 20.10.1998 FR 9813136
(43) Date de publication de la demande: 26.04.2000
(73) Titulaire: COMMISSARIAT A L'ENERGIE ATOMIQUE, 75015 Paris (FR)
(72) Inventeur: Joly, Jean-Pierre, 38120 Saint-Egreve (FR); Aspar, Bernard, 38140 Rives (FR); Biasse, Béatrice, 38410 Uriage (FR); Zussy, Marc, 38000 Grenoble (FR)
(74) Mandataire: Audier, Philippe André

(56) Documents cités:
- EP-A- 0 168 815
- DE-A- 4 434 040
- FR-A- 2 038 226

## Description

### Domaine technique

La présente invention concerne un procédé de réalisation de composants passifs et actifs sur un même substrat isolant. Elle s'applique en particulier à la réalisation de circuits hyperfréquences et notamment les composants hyperfréquence intégrés dits "Monolithic Microwave Integrated Circuits" (MMIC) comportant à la fois des composants actifs (transistors) et des composants passifs intégrés (par exemple des inductances).

### Etat de la technique antérieure

Les circuits hyperfréquences sont constitués de composants actifs (par exemple des transistors) et de composants ou d'éléments passifs (par exemple des résistances, des capacités, des inductances et des lignes conductrices). Les performances de ces circuits en terme de rapidité et de gain sont liées à celles des composants actifs (rapidité, gain, tenue en tension...) mais aussi aux pertes dans les composants passifs. On peut réaliser les circuits hyperfréquences de deux façons différentes :
1) soit à partir d'éléments passifs et actifs réalisés séparément et assemblés dans des modules hybrides,
2) soit de façon monolithique. Les éléments passifs sont alors dessinés et réalisés sous forme de lignes métalliques sur le même substrat semiconducteur que celui dans lequel sont fabriqués les éléments actifs.

Dans ce second cas, les pertes dans les éléments passifs sont très fortement augmentées en raison de la conductivité du substrat semiconducteur.

Un bon substrat pour les composants hyperfréquences est en fait un substrat isolant de faible constante diélectrique. Il est en effet important d'éloigner au maximum les éléments passifs de tout matériau conducteur. Cependant, il est impossible d'obtenir des substrats en silicium parfaitement isolants. C'est une des raisons pour lesquelles on privilégie d'autres semiconducteurs comme l'AsGa, qui peut être lui semi-isolant, pour la réalisation des composants hyperfréquences de haute performance.

L'utilisation de matériaux semiconducteurs autres que le silicium n'est toutefois pas satisfaisante pour deux raisons :
- la fabrication de composants devient alors nettement plus chère ;
- on cherche de plus en plus, notamment pour le matériel électronique portable (voir l'article "High-Frequency Semiconductor Devices for Mobile Telecommunication Systems" de C. KUSANO et al., Hitachi Review Vol. 46, 1997, N° 1), à rassembler sur la même puce tous les composants analogiques hyperfréquences (réception, émission, modulation, amplification) ainsi que la partie de commande et de traitement logique (bande de base). On parle alors de circuits "mixtes" ou "Mixed-mode ICs" dans la terminologie anglo-saxonne (voir le brevet US 5 492 857). Le matériau de prédilection pour la fabrication de circuits logiques est le silicium. Il reste le seul matériau envisagé pour ces fonctions logiques et cela pour de nombreuses années. Ajouter des fonctions hyperfréquences sur la même puce en silicium suppose de résoudre les problèmes de pertes dans les éléments passifs liés à la conductibilité non nulle du substrat en silicium, mais aussi celui du couplage entre les parties hyperfréquences et les parties logiques du circuit, couplage dû également au substrat conducteur. Ces couplages induisent des perturbations pouvant être néfastes sur les signaux logiques. Actuellement, il n'existe donc pas sur le marché de circuits mixtes.

Les circuits hyperfréquences sont donc réalisés sur des puces spécifiques soit sur GaAs, soit sur silicium.

Plusieurs solutions ont été proposées pour diminuer l'impact négatif du substrat en silicium.

Une première solution consiste à utiliser des substrats de type SOI (Silicium Sur Isolant). Ces structures sont particulièrement attrayantes pour la partie logique des circuits mixtes (diminution de la consommation). Elles ne représentent par contre qu'une solution très imparfaite au problème des pertes dans le substrat qui reste du silicium plus ou moins conducteur. L'utilisation de silicium de type "Fusion de zone" de haute résistivité a été proposé (voir l'article "MICROX™- An All-Silicon Technology for Monolithic Microwave Integrated Circuits" de M.H. HANES et al., IEEE Electron Device Letters, Vol. 14, N° 5, Mai 1993, pages 219-221) mais, outre qu'il ne supprime pas complètement les pertes, ce type de substrat est cher et indisponible pour des diamètres supérieurs à 150 mm.

Une deuxième solution consiste à utiliser des substrats de type Silicium sur Saphir (SOS) comme cela est divulgué dans le brevet US 5 492 857. Les substrats SOS sont réalisés par une hétéroépitaxie de silicium sur un substrat monocristallin de corindon (Al₂O₃) qui est un isolant. Dans ce cas, comme dans le cas du SOI, les composants actifs sont réalisés dans une fine couche de silicium en surface et isolés entre eux par l'élimination localisée de la couche de silicium. Les composants passifs peuvent être alors réalisés par des métallisations placées à côté des composants actifs. Le fait que le substrat soit parfaitement isolant permet d'obtenir de très faibles pertes pour ces composants passifs. Des circuits hyperfréquences ont été réalisés sur ces substrats avec des résultats tout à fait intéressants. Néanmoins, ces substrats possèdent des inconvénients majeurs. Ils sont chers et difficiles à manipuler dans les lignes de fabrication de dispositifs et requièrent des procédés spécifiques. De plus, la couche de silicium épitaxié est d'assez mauvaise qualité cristalline.

Une troisième solution consiste à utiliser des substrats en silicium classiques (massifs) mais avec une conception spécifique des éléments passifs sur plusieurs niveaux de couches de métallisation et l'éloignement des couches métalliques constituant les éléments passifs par des couches épaisses d'isolant (voir l'article "Integrated RF and Microwave Components in BiCMOS Technology" de J.N. BURGHARTZ et al., IEEE Transactions on Electron Devices, Vol. 43, N° 9, septembre 1996, pages 1559-1570). Là encore, ce n'est pas une solution satisfaisante car l'effet du substrat conducteur, bien que diminué, est encore notable. Ici comme dans le cas du substrat SOI on trouve le recours éventuel au substrat en silicium de haute résistivité de type fusion de zone.

### Exposé de l'invention

Pour remédier aux problèmes exposés ci-dessus, il est proposé par la présente invention une technique originale pour la réalisation de circuits électroniques incluant des composants actifs, des composants et/ou des éléments passifs. Cette technique s'applique en particulier à la réalisation de circuits hyperfréquences.

L'invention a donc pour objet le procédé de réalisation d'au moins une structure électronique comportant au moins un composant actif et au moins un composant ou élément passif sur un substrat support en matériau isolant, présentant les caractéristiques de la revendication 1.

Le substrat initial peut comprendre en outre une couche isolante entre la plaquette de matériau semiconducteur et la couche superficielle.

Les zones d'isolation électrique peuvent être obtenues par oxydation de la couche superficielle, à l'exception de la zone où est formé ledit composant actif. Elles peuvent encore être obtenues par bombardement par des particules de la couche superficielle, à l'exception de la zone où est formé ledit composant actif, ce bombardement par des particules permettant de rendre isolant le matériau semiconducteur.

La réalisation des zones d'isolation électrique peut comporter la formation d'une couche isolante.

Avantageusement, le composant ou élément passif est réalisé par dépôt et photolithogravure de couche métallique.

La préparation de surface peut comprendre le dépôt d'une couche de planarisation sur ladite face à coller, suivi d'un polissage de cette couche de planarisation.

L'étape de collage peut être réalisée en choisissant le substrat support parmi des substrats en quartz, en silice, en verre et en saphir.

L'élimination de tout ou partie de la plaquette de matériau semiconducteur peut être effectuée selon une méthode choisie parmi ou combinant : la rectification, l'attaque chimique sélective, le polissage, le clivage résultant de la coalescence suite à un traitement thermique de microcavités générées par implantation ionique.

Le procédé exposé ci-dessus fournit des composants renversés par rapport aux procédés classiques ou des composants dans le sens usuel.

L'étape de collage de la face révélée peut être réalisée en choisissant le deuxième substrat rapporté parmi des substrats en quartz, en silice, en verre et en saphir.

L'élimination du premier substrat rapporté peut être effectuée selon une méthode choisie parmi ou combinant : la rectification, l'attaque chimique sélective, le polissage, le clivage résultant de la coalescence suite à un traitement thermique de microcavités générées par implantation ionique.

### Brève description des dessins

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A à 1G illustrent différentes étapes d'un premier mode de mise en oeuvre de la présente invention,
- les figures 2A à 2D illustrent différentes étapes d'un deuxième mode de mise en oeuvre de la présente invention,
- les figures 3A à 3E illustrent différentes étapes d'un troisième mode de mise en oeuvre de l'invention,
- les figures 4A et 4B illustrent des étapes d'un quatrième mode de mise en oeuvre de l'invention.

### Description détaillée de modes de réalisation de l'invention

L'adhérence moléculaire implique l'absence de tout matériau diélectrique autre que les matériaux minéraux classiques utilisés en microélectronique (essentiellement la silice, SiO₂). Ceci est un gage de fiabilité pour les circuits (absence de dégradations mécaniques et électriques soit lors de la suite du processus de fabrication, soit lors de l'utilisation du composant). De plus, en ce qui concerne les circuits MMIC, les polymères, s'ils sont généralement de bons isolants, ne sont pas forcément exempts de phénomènes de pertes à haute fréquence.

L'adhérence moléculaire entre deux substrats (ou collage direct) nécessite l'adéquation entre trois paramètres : la planéité de la surface, la rigidité des substrats (liée à l'épaisseur et aux coefficients d'élasticité mécanique) et l'énergie de collage (liée aux liaisons chimiques moléculaires formées entre les deux surfaces).

Le dépôt d'une couche d'un matériau minéral, par exemple de type silice, sur la surface d'un circuit réalisé dans un substrat procure une bonne adhérence moléculaire par le phénomène d'adsorption de molécules d'eau. La silice est un matériau particulièrement bien adapté pour former cette couche.

En l'absence d'un traitement particulier, l'état de surface d'une couche diélectrique de type silice déposée en fin de fabrication d'un composant ne permet pas une bonne adhérence moléculaire, sans défauts macroscopiques (zones non collées, voire absence totale de collage). Il est donc avantageux de respecter les modalités suivantes :
- Dépôt d'une couche du type silice en fin de procédé, d'une épaisseur supérieure à une valeur de seuil dépendant de la topologie résiduelle du circuit avant cette étape. Le dépôt doit être le plus conforme possible de façon à remplir autant que faire se peut les sillons créés par les motifs antérieurs dans les couches sous-jacentes.
- Planarisation de cette couche par exemple par une technique de polissage comme le polissage mécano-chimique. La quantité de matière enlevée au cours de cette étape est à adapter à la topologie présentée après le dépôt de la couche minérale pour obtenir en fin de polissage une surface suffisamment plane à tous les niveaux. La planéité doit en particulier être suffisamment bonne par rapport à la rigidité du substrat comportant le circuit, au moment du collage.
- Nettoyage et traitement chimique particulier ayant pour objet à la fois d'enlever les particules subsistantes et d'induire le maximum de liaisons chimiques favorables à l'adhérence moléculaire (forte énergie de collage).

Avant collage, il est très utile de préparer la surface du substrat d'accueil de façon à lui donner également les caractéristiques nécessaires pour un collage moléculaire. Certains substrats de verre ou de silice conviennent particulièrement bien à l'adhérence moléculaire (bonne planéité et liaisons chimiques en surface).

Le collage direct peut alors être obtenu par simple mise en contact (propagation d'une onde de collage). Avant élimination du substrat semiconducteur, un recuit à la température maximum admissible par les éléments du circuit peut être effectué de façon à renforcer au maximum les forces de collage.

Toutes ces opérations peuvent se pratiquer sur les machines usuelles utilisées en micro-électronique.

Selon la présente invention, les composants passifs peuvent être fabriqués sur des zones d'isolation électrique entre composants actifs et se retrouvent donc sur un substrat entièrement isolant donc sans pertes. Les facteurs de qualité des résonateurs ainsi réalisés sont notablement améliorés. Les caractéristiques du circuit sont donc meilleures, en particulier par rapport à l'art antérieur qui utilise un collage par colles en polymère.

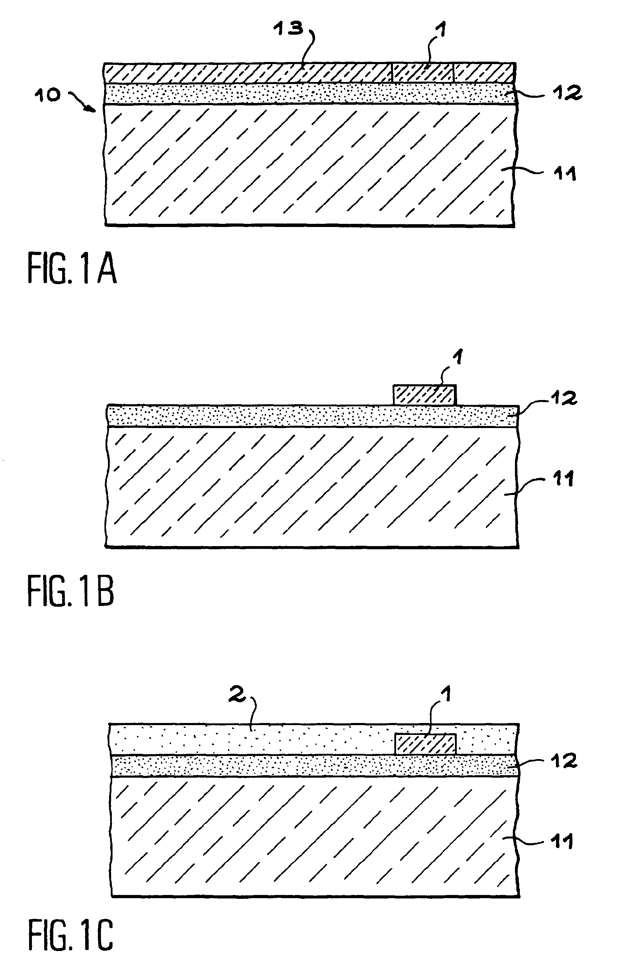

Un premier mode de mise en oeuvre de l'invention est illustré par les figures 1A à 1G. Par souci de simplification, la structure électronique à élaborer ne comprendra qu'un seul composant actif et un élément passif.

La figure 1A représente, en vue transversale et à titre d'exemple, un substrat SOI 10 constitué d'une plaquette de silicium 11 recouverte d'une couche d'oxyde de silicium 12, elle-même recouverte d'une couche superficielle de silicium 13. Par une méthode connue de l'homme de l'art, on a réalisé dans la couche superficielle 13 un composant actif 1, par exemple un transistor.

Afin de réaliser une isolation latérale du composant actif 1, la couche superficielle de silicium est entièrement éliminée à l'exception de la zone constituant le composant actif. Cette élimination peut être obtenue par gravure poursuivie jusqu'à la couche d'oxyde 12 après masquage du composant actif 1. C'est ce que représente la figure 1B.

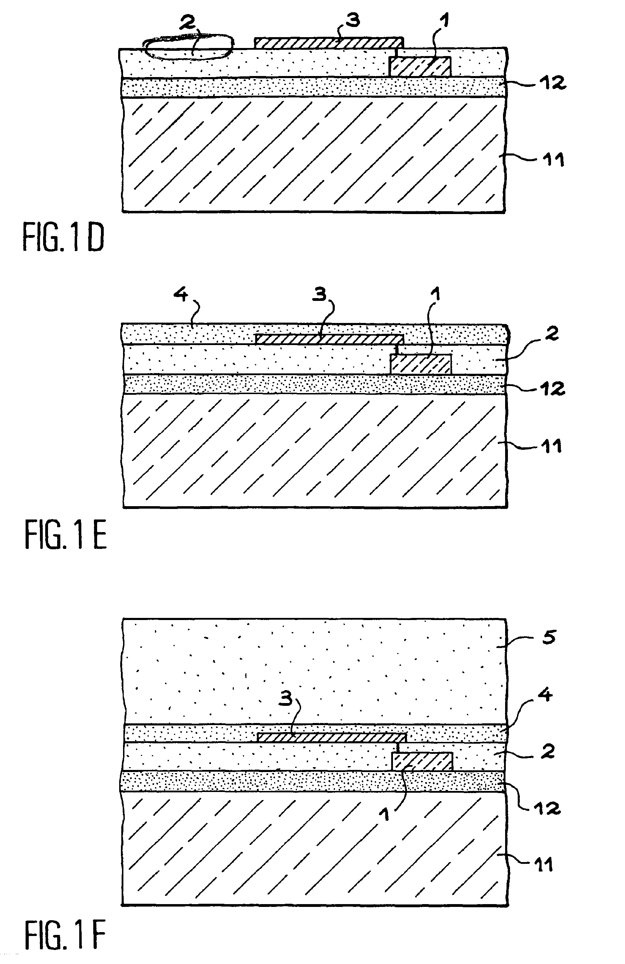

Une couche d'un matériau diélectrique 2 est ensuite déposée sur la couche d'oxyde 12 en englobant le composant actif 1 comme le montre la figure 1C. Sur la couche de matériau diélectrique 2 on réalise, par dépôt et photolithogravure de couche métallique, l'élément passif 3 relié électriquement au composant actif 2 (voir la figure 1D).

La face supérieure de la structure empilée telle que représentée sur la figure 1D est ensuite préparée de manière à la rendre compatible pour un collage avec un autre substrat. On peut par exemple planariser la structure. Cette planarisation peut consister à déposer une couche de silice 4 sur la face concernée (voir la figure 1E), puis à polir cette couche de silice 4 par polissage mécano-chimique selon des procédés usuels en micro-électronique.

La face supérieure de la couche de silice 4 est alors collée sur un substrat en matériau isolant 5 (voir la figure 1F). Le substrat 5 peut avantageusement être en quartz, en silice, en verre ou en saphir. Pour un collage par adhérence moléculaire, les surfaces des éléments à coller sont traitées de manière appropriée. La planarisation de ces surfaces est un critère essentiel pour obtenir un bon collage. Pour renforcer la tenue mécanique du collage par adhérence moléculaire il peut être utile de soumettre l'interface de collage à un traitement thermique. Ce traitement thermique doit être compatible avec les composants électroniques élaborés précédemment.

La plaquette de silicium 11 du substrat SOI est ensuite éliminée. Pour obtenir ce résultat, plusieurs techniques peuvent être utilisées soit isolément, soit de manière combinée : la rectification, l'attaque chimique sélective, le polissage, en s'arrêtant sur la couche de silice 12. On peut encore utiliser la technique divulguée par le document FR-A-2 681 472. Pour cela le substrat SOI aura été au préalable traité par implantation ionique afin de former une couche de microcavités le long d'un plan de clivage. L'élimination de la plaquette de silicium peut être obtenue, lors de la dernière étape du procédé selon la présente invention, par un traitement thermique permettant la coalescence des microcavités.

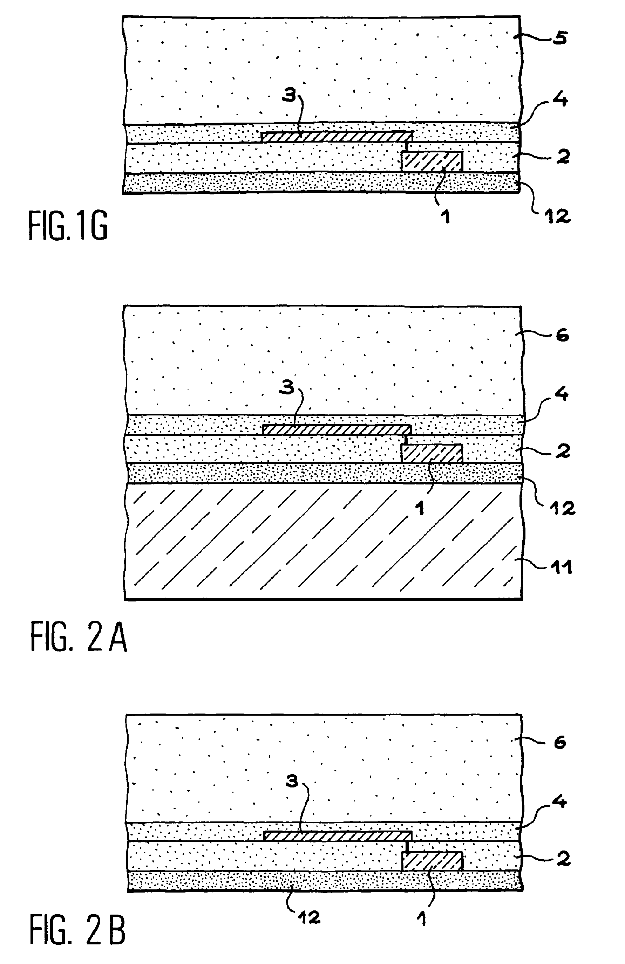

La structure finalement obtenue se présente comme le représente la figure 1G. Il restera ensuite à ouvrir, selon des techniques connues, les couches d'isolant 12 et 2 au niveau des plots de connexion. Dans ce mode de réalisation, l'élimination du matériau semiconducteur dans les zones de la couche superficielle situées en dehors du composant actif a été réalisée par gravure de la couche superficielle de silicium et par dépôt d'une couche de matériau diélectrique. Il est possible d'obtenir un matériau isolant en dehors du composant actif par d'autres méthodes. On peut par exemple oxyder localement le silicium entourant le composant actif et réaliser le composant ou élément passif sur cette couche de silicium oxydé. Une autre solution pour obtenir un matériau isolant en dehors du composant actif consiste à bombarder la couche superficielle par des particules, par exemple on peut effectuer une implantation ionique. La couche superficielle de silicium est donc conservée partout. Les zones de silicium situées sous les composants (ou éléments) passifs sont bombardées par des ions de façon à rendre isolant le silicium (création de défauts : pièges à porteurs). La dose et l'énergie du bombardement sont calibrées pour obtenir une forte résistivité de la couche superficielle sur toute son épaisseur. Cette opération de bombardement doit être réalisée après tout traitement thermique élevé qui risquerait autrement de "recuire" les défauts volontairement créés dans le silicium par bombardement. Cette technique d'isolation électrique est facile à mettre en oeuvre et présente l'avantage de conserver la planéité de la structure.

Le premier mode de mise en oeuvre de l'invention conduit à une présentation des composants de manière renversée par rapport au sens usuel. Le deuxième mode de réalisation, qui va maintenant être décrit en référence aux figures 2A à 2D permet d'avoir les composants dans le sens usuel.

Les premières étapes du deuxième mode de réalisation sont identiques à celles du premier mode décrit ci-dessus et ne seront donc pas décrites. On suppose donc disposer d'une structure telle que représentée à la figure 1E.

La figure 2A représente la structure en cours d'élaboration et comprenant un substrat 6 collé sur la couche de silice 4. Ce substrat 6 peut être quelconque et pas forcément isolant. Le collage peut être réalisé par adhésion moléculaire.

La figure 2B représente la structure après élimination de la plaquette de silicium du substrat SOI. L'élimination de cette plaquette peut être réalisée par les techniques décrites pour le premier mode de réalisation.

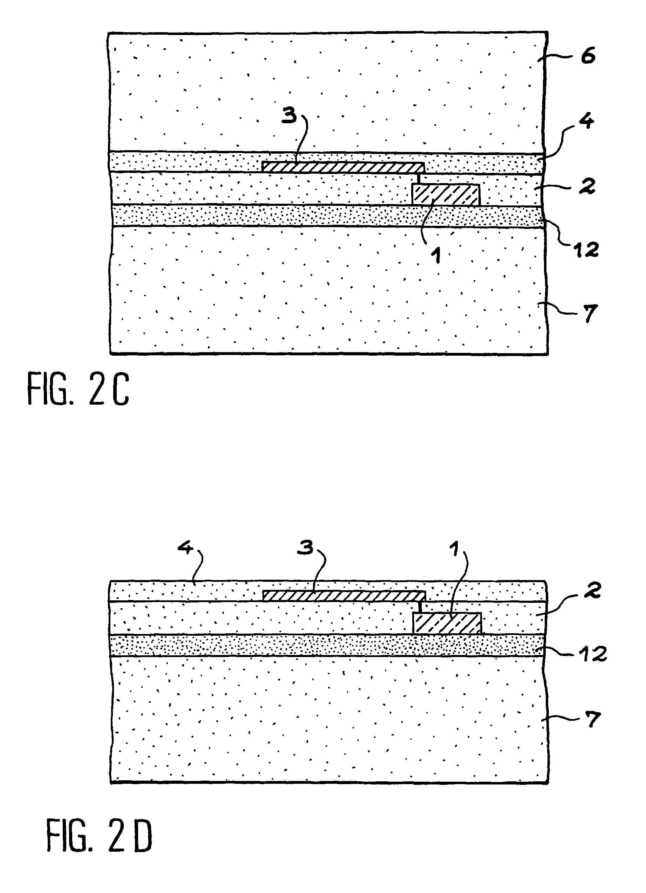

La structure obtenue est ensuite collée par la couche de silice 12 à son substrat support en matériau isolant 7 comme le montre la figure 2C. Le collage se faisant par adhésion moléculaire, les faces à coller de la couche 12 et du substrat 7 ont été préparées en conséquence.

Le substrat 6 est ensuite éliminé par l'une des techniques énumérées plus haut et on obtient la structure représentée à la figure 2D où les composants se présentent dans le sens usuel.

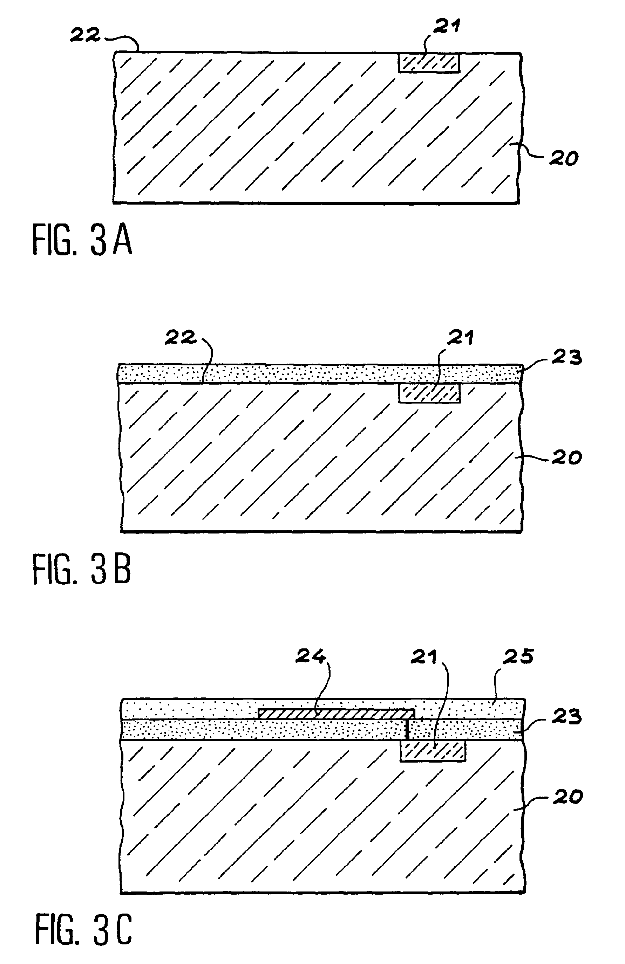

Un troisième mode de réalisation de l'invention va maintenant être décrit en référence aux figures 3A à 3E. Selon ce mode de réalisation, les composants sont présentés de manière renversée par rapport au sens usuel.

On part d'un substrat massif 20 par exemple en silicium. A partir de la face 22 du substrat 20, on réalise, dans la couche superficielle de ce substrat, un composant actif 21 (voir la figure 3A). La face 22 est ensuite recouverte d'une couche 23 de matériau diélectrique qui recouvre également le composant actif 21 (voir la figure 3B). Sur la couche de matériau diélectrique 23 on réalise, par dépôt et photolithogravure de couche métallique, l'élément passif 24 relié électriquement au composant actif 21 (voir la figure 3C).

La face supérieure de la structure empilée telle que représentée à la figure 3C est ensuite préparée de manière à la rendre compatible pour un collage avec un autre substrat. On peut par exemple planariser la structure. Cette planarisation peut consister à déposer une couche de silice 25 sur la face concernée, puis à polir cette couche 25 par polissage mécano-chimique.

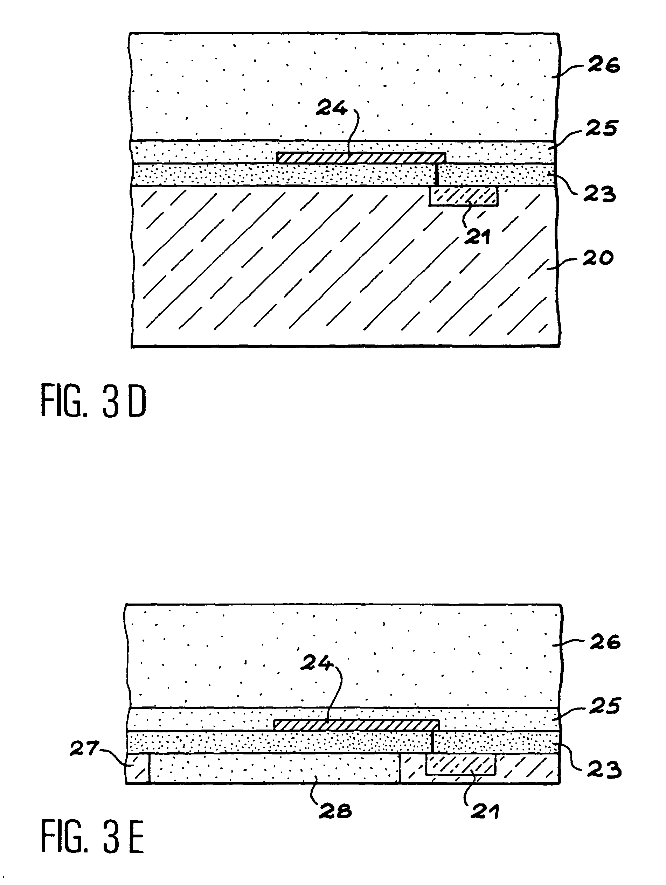

La face supérieure de la couche 25 est alors collée sur un substrat en matériau isolant 26 (voir la figure 3D). Ce substrat 26 peut avantageusement être en quartz, en silice, en verre ou en saphir. Le collage peut être réalisé par adhérence moléculaire.

Le substrat 20 est ensuite en grande partie éliminé, par exemple par rectification ou polissage. Cette élimination est arrêtée avant d'atteindre le composant actif 21 comme le montre la figure 3E. C'est donc pratiquement la couche superficielle 27, dans laquelle a été réalisé le composant actif, qui subsiste. Le composant actif 21 est recouvert d'une fine épaisseur du matériau du substrat initial.

Dans ce mode de réalisation, la partie de la couche superficielle en dehors du composant actif peut être conservée telle quelle. Elle peut aussi être rendue isolante comme le montre la figure 3E où une zone 28 de cette couche superficielle a été rendue isolante par exemple par gravure et formation d'isolant, par oxydation ou encore par bombardement localisé de particules.

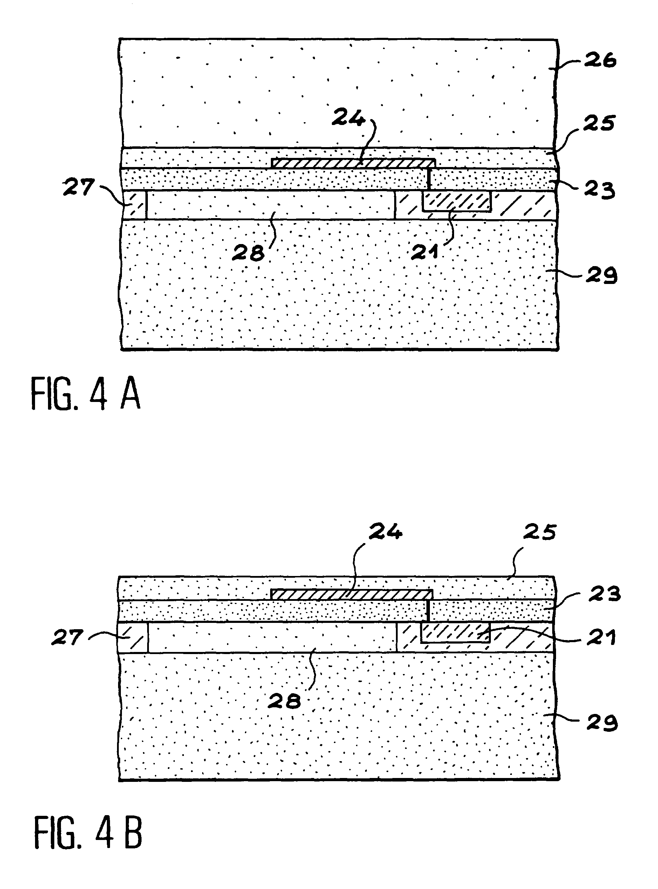

Ce troisième mode de réalisation conduit à une présentation des composants de manière renversée par rapport au sens usuel. Le quatrième mode de réalisation qui va maintenant être décrit en référence aux figures 4A et 4B permet d'avoir les composants dans le sens usuel.

Les premières étapes du quatrième mode de réalisation sont identiques aux étapes du troisième mode décrit ci-dessus. On suppose donc disposer d'une structure telle que représentée à la figure 3E.

La figure 4A montre que la couche superficielle a été collée à un substrat support 29 en matériau isolant. Selon ce quatrième mode de réalisation, le substrat 26 n'est pas forcément isolant. Il peut être en matériau semiconducteur.

La figure 4B représente la structure obtenue après élimination du substrat 26. L'élimination de ce substrat peut être réalisée par les techniques décrites précédemment.

La présente invention présente les avantages suivants par rapport à l'état de l'art connu.

Les composants passifs réalisés sont disposés au-dessus d'un substrat isolant sans la présence de couches conductrices sous-jacentes ou avec la présence d'une couche semiconductrice de faible épaisseur. L'invention partage cet avantage avec la technique Silicium sur Saphir (SOS). Il y a suppression totale ou forte diminution des pertes et des effets de couplage par le substrat et donc possibilité de réaliser des circuits hyperfréquences performants et possibilité d'ajouter toutes les fonctions électroniques voulues sans risque de couplage et d'interférence.

Les composants sont réalisés au départ sur un substrat avec des techniques usuelles. En particulier, il n'y a pas de risque de casse ni de pollution lié au substrat contrairement au cas du SOS. Le report de la couche active sur substrat isolant n'est effectué qu'à l'issue du cycle de fabrication du composant. L'utilisation de techniques Silicium sur Isolant est de plus un critère de choix pour la réalisation de circuits rapides et à faible consommation, ce qui est très avantageux pour les applications de l'électronique portable.

Il est possible d'utiliser des substrats isolants de diamètre compatible avec celui de tranches de silicium et de faible coût, comme les verres à usage électronique.

Le surcoût introduit par la mise en oeuvre de l'invention est modéré par rapport à une fabrication de circuits sur silicium.

## Revendications

1. Procédé de réalisation d'au moins une structure électronique comportant au moins un composant actif (1) et au moins un composant ou élément passif (3) sur un substrat support en matériau isolant (5, 6), **caractérisé en ce qu'**il comprend les étapes suivantes:
a) réalisation du composant actif (1) dans une couche superficielle (13) en matériau semi-conducteur d'un substrat initial (10) comprenant une plaquette de matériau semi-conducteur (11) supportant ladite couche superficielle,
b) isolation latérale du composant actif (1) par élimination de la couche superficielle à l'exception du composant actif (1),
c) dépôt d'un matériau diélectrique (2) englobant le composant actif (1) pour former des zones d'isolation électrique aptes à isoler le composant ou élément passif (3) du composant actif (1),
d) réalisation du composant ou élément passif (3) sur et/ou dans les zones d'isolation électrique (2),
e) préparation de surface de la face du substrat initial présentant ladite structure électronique pour rendre cette face compatible pour un collage par adhésion moléculaire avec un premier substrat rapporte (5, 6),
f) réalisation dudit collage,
g) élimination de tout ou partie de la plaquette de matériau semi-conducteur (11).

2. Procédé selon la revendication 1, **caractérisé en ce qu'**il comprend en sus les étapes suivantes:
h) préparation de surface de la face de la plaquette de matériau semi-conducteur révélée par l'étape d'élimination g) pour rendre cette face compatible pour un collage par adhésion moléculaire avec un deuxième substrat rapporté (7),
i) réalisation dudit collage de la face révélée avec le deuxième substrat rapporte (7) qui est constitue de matériau isolant,
j) élimination du premier substrat rapporté (6).

3. Procédé selon la revendication 1 ou 2, **caractérisé en ce que** le substrat initial (10) comprend en outre une couche isolante (12) entre la plaquette de matériau semi-conducteur (11) et la couche superficielle (13).

4. Procédé selon la revendication 1 ou 2, **caractérisé en ce que** les zones d'isolation électrique sont obtenues par oxydation de la couche superficielle, à l'exception de la zone ou est formé ledit composant actif.

5. Procédé selon la revendication 1 ou 2, **caractérisé en ce que** les zones d'isolation électrique sont obtenues par bombardement par des particules de la couche superficielle, à l'exception de la zone ou est formé ledit composant actif, ce bombardement par des particules permettant de rendre isolant le matériau semi-conducteur.

6. Procédé selon l'une quelconque des revendications 1 à 5, **caractérisé en ce que** la réalisation de zones d'isolation électrique comporte la formation d'une couche isolante (2).

7. Procédé selon l'une quelconque des revendications 1 à 6, **caractérisé en ce que** le composant ou élément passif (3) est réalisé par dépôt et photolithogravure de couche métallique.

8. Procédé selon l'une quelconque des revendications 1 à 7, **caractérisé en ce que** ladite préparation de surface (étape e) et/ou h)) comprend le dépôt d'une couche de planarisation sur ladite face à coller, suivi d'un polissage de cette couche de planarisation.

9. Procédé selon l'une quelconque des revendications 1 à 8, **caractérisé en ce que** ladite étape de collage du substrat initial avec le premier substrat rapporté (5, 6) est réalisée en choisissant le substrat support (5, 6) parmi des substrats en quartz, en silice, en verre et en saphir.

10. Procédé selon l'une quelconque des revendications 1 à 9, **caractérisé en ce que** l'élimination de tout ou partie de la plaquette de matériau semi-conducteur (11) est effectuée selon une méthode choisie parmi ou combinant: la rectification, l'attaque chimique sélective, le polissage, le clivage résultant de la coalescence suite à un traitement thermique de microcavités générées par implantation ionique.

11. Procédé selon l'une quelconque des revendications 1 à 10, **caractérisé en ce que** ladite étape de collage de la face révélée est réalisée en choisissant le deuxième substrat rapporté (7) parmi des substrats en quartz, en silice, en verre et en saphir.

12. Procédé selon l'une quelconque des revendications 1 à 11, **caractérisé en ce que** l'élimination du premier substrat rapporte (5, 6) est effectuée selon une méthode choisie parmi ou combinant: la rectification, l'attaque chimique sélective, le polissage, le clivage résultant de la coalescence suite à un traitement thermique de microcavites générées par implantation ionique.

## Claims

1. Process for the manufacture of at least one electronic structure comprising at least one active component (1) and at least one passive component or element (3) on a support substrate made of an insulating material (5, 6), **characterized in that** it comprises the following steps:
a) making the active component (1) in a surface layer (13) made of semiconducting material (10) from an initial substrate comprising a wafer of semiconducting material (11) supporting said surface layer,
b) lateral insulating of the active component (1) by eliminating the surface layer except for the active component (1),
c) depositing a dielectric material (2) surrounding the active component (1) to form electrical insulation areas capable of insulating the passive component or element (3) from the active component (1),
d) making the passive component or element (3) on and/or in the electrical insulation areas (2),
e) preparing the surface of the initial substrate face with said electronic structure to make this face compatible for bonding with a first add-on substrate (5, 6) by molecular bonding,
f) performing said bonding,
g) eliminating all or part of the wafer made of semiconducting material (11).

2. Process according to claim 1, **characterized in that** it further comprises the following steps:
h) preparing the surface of the face of the wafer of semiconducting material exposed by the elimination step g) to make this face compatible for molecular bonding with a second add-on substrate (7),
i) performing said bonding of the exposed face with the second add-on substrate (7) made of an insulating material,
j) eliminating the first add-on substrate (6).

3. Process according to claim 1 or 2, **characterized in that** the initial substrate (10) also comprises an insulating layer (12) between the wafer made of semiconducting material (11) and the surface layer (13).

4. Process according to claim 1 or 2, **characterized in that** the electrical insulation areas are obtained by oxidation of the surface layer, except for the area in which said active component is formed.

5. Process according to claim 1 or 2, **characterized in that** the electrical insulation areas are obtained by bombardment of the surface layer by particles, except for the area in which said active component is formed, this bombardment by particles making the semiconducting material insulating.

6. Process according to any one of claims 1 to 5, **characterized in that** the manufacture of the electrical insulation areas includes the formation of an insulating layer (2).

7. Process according to any one of claims 1 to 6, **characterized in that** the passive component or element (3) is made by deposition and photolitho-etching of metallic layer.

8. Process according to any one of claims 1 to 7, **characterized in that** said surface preparation (step e) and/or h)) includes the deposition of a planarization layer on said face to be bonded, hollowed by polishing this planarization layer.

9. Process according to any one of claims 1 to 8, **characterized in that** said bonding step of the initial substrate with the first add-on substrate (5, 6) is done by choosing the support substrate (5, 6) among quartz, silica, glass and sapphire substrates.

10. Process according to any one of claims 1 to 9, **characterized in that** eliminating all or part of the wafer of semiconducting material (11) is realized using one of the following methods, or a combination of them: grinding, selective chemical etching, polishing, cleavage caused by coalescence following a heat treatment of micro-cavities generated by ionic implantation.

11. Process according to any one of claims 1 to 10, **characterized in that** said step in which the exposed face is bonded is carried out choosing a quartz, silicon, glass or sapphire substrate as the second add-on substrate (7).

12. Process according to any one of claims 1 to 11, **characterized in that** the first add-on substrate (5, 6) is eliminated according to one of the following methods, or a combination of these method: grinding, selective chemical etching, polishing, cleavage caused by coalescence following a heat treatment of micro-cavities generated by ionic implantation.

## Patentansprüche

1. Verfahren zur Herstellung von wenigstens einer elektronischen Struktur mit wenigstens einem aktiven Bauelement (1) und wenigstens einem passiven Bauelement (3) auf einem Trägersubstrat aus isolierendem Material (5, 6),
**dadurch gekennzeichnet, dass** es die folgenden Schritte umfasst:
a) Erzeugung des aktiven Bauelements (1) in einer Halbleiteroberflächenschicht (13) eines Initialsubstrats (10), das eine die genannte Oberflächenschicht tragende Halbleitermaterialplatte (11) umfasst,
b) seitliche Isolierung des aktiven Bauelements (1) durch Elimination der Oberflächenschicht mit Ausnahme des aktiven Bauelements (1),
c) Abscheidung eines das aktive Bauelement umhüllenden dielektrischen Materials (2) zur Bildung von elektrischen Isolationszonen, dazu bestimmt, das passive Bauelement (3) von dem aktiven Bauelement (1) zu isolieren,
d) Erzeugung des passiven Bauelements (3) auf und/oder in den elektrischen Isolationszonen (2),
e) Präparation der Oberfläche der die genannte elektronische Struktur aufweisenden Seite des Initialsubstrats, um diese Seite kompatibel zu machen für ein Zusammenkleben mit einem ersten Anbau-Substrat (5, 6) mittels Molekularadhäsion,
f) Realisation des genannten Zusammenklebens,
g) Elimination der Halbleitermaterialplatte (11) ganz oder teilweise.

2. Verfahren nach Anspruch 1, **dadurch gekennzeichnet, dass** es außerdem die folgenden Schritte umfasst:
h) Präparation der Oberfläche der durch den Schritt g) freigemachten Seite der Halbleitermaterialplatte, um diese Seite kompatibel zu machen für ein Zusammenkleben mit einem zweiten Anbau-Substrat (7) mittels Molekularadhäsion,
i) Realisierung des Zusammenklebens der freigemachten Seite mit dem zweiten Anbau-Substrat (7) aus isolierendem Material,
j) Elimination des ersten Anbau-Substrats (6).

3. Verfahren nach Anspruch 1 oder 2, **dadurch gekennzeichnet, dass** das Initialsubstrat (10) außerdem eine Isolationsschicht (12) umfasst, zwischen der Halbleitermaterialplatte (11) und der Oberflächenschicht (13).

4. Verfahren nach Anspruch 1 oder 2, **dadurch gekennzeichnet, dass** man die elektrischen Isolationszonen erzeugt, indem man die Oberflächenschicht mit Ausnahme der Zone oxidiert, wo das genannte aktive Bauelement ausgebildet ist.

5. Verfahren nach Anspruch 1 oder 2, **dadurch gekennzeichnet, dass** man die elektrischen Isolationszonen erzeugt durch Partikelbombardierung der Oberflächenschicht mit Ausnahme der Zone, wo das genannte aktive Bauelement ausgebildet ist, wobei diese Partikelbombardierung ermöglicht, das Halbleitermaterial isolierend zu machen.

6. Verfahren nach einem der Ansprüche 1 bis 5, **dadurch gekennzeichnet, dass** die Realisation der elektrischen Isolationszonen die Bildung einer Isolationsschicht (2) umfasst.

7. Verfahren nach einem der Ansprüche 1 bis 6, **dadurch gekennzeichnet, dass** das passive Bauelement (3) durch Abscheidung und Metallschicht-Fotolithographie realisiert wird.

8. Verfahren nach einem der Ansprüche 1 bis 7, **dadurch gekennzeichnet, dass** die genannte Oberflächenpräparation (Schritt e) und/oder h)) das Abscheiden einer Planarisierungsschicht auf der genannten Klebungsseite umfasst, gefolgt von einer Politur dieser Planarisierungsschicht.

9. Verfahren nach einem der Ansprüche 1 bis 8, **dadurch gekennzeichnet, dass** der genannte Schritt des Zusammenklebens des Initialsubstrats mit dem Anbau-Substrat (5, 6) realisiert wird, indem man das Anbau-Substrat (5, 6) auswählt unter Substraten aus Quarz, aus Siliciumdioxid, aus Glas und aus Saphir.

10. Verfahren nach einem der Ansprüche 1 bis 9, **dadurch gekennzeichnet, dass** die Elimination - ganz oder teilweise - der Halbleitermaterialplatte (11) nach folgenden Methoden - einzeln oder kombiniert - erfolgt: Feinschleifen, selektives Ätzen, Polieren, Spalten, resultierend aus der Koaleszenz infolge einer thermischen Behandlung von Mikrohohlräumen, erzeugt durch Ionenimplantation.

11. Verfahren nach einem der Ansprüche 1 bis 10, **dadurch gekennzeichnet, dass** der genannte Schritt zur Verklebung der freigemachten Seite realisiert wird indem das zweite Anbau-Substrat (7) ausgewählt wird unter Substraten aus Quarz, aus Siliciumdioxid, aus Glas und aus Saphir.

12. Verfahren nach einem der Ansprüche 1 bis 11, **dadurch gekennzeichnet, dass** die Elimination des ersten Anbau-Substrats (5, 6) nach folgenden Methoden - einzeln oder kombiniert - erfolgt: Feinschleifen, selektives Ätzen, Polieren, Spalten, resultierend aus der Koaleszenz infolge einer thermischen Behandlung von Mikrohohlräumen, erzeugt durch lonenimplantation.
